# FASCICULE DE BREVET EUROPEEN

(11) **EP 1 931 816 B1**
(45) Date de publication et mention de la délivrance du brevet: **09.12.2020**
(21) Numéro de dépôt: 06808211.4
(22) Date de dépôt: 28.09.2006
(51) Int. Cl.: C23C 16/36, C23C 28/00, C23C 28/04, C23C 30/00

(54) **REVETEMENT ANTI-CORROSION A BASE DE SILICIUM, DE CARBONE, D'HYDROGENE ET D'AZOTE**
KORROSIONSSCHUTZSCHICHT AUF BASIS VON SILIZIUM, KOHLENSTOFF, WASSERSTOFF UND STICKSTOFF
CORROSION RESISTANT COATING BASED ON SILICON, CARBON, HYDROGEN AND NITROGEN

(30) Priorité: 03.10.2005 FR 0510083
(43) Date de publication de la demande: 18.06.2008
(60) Demande divisionnaire: 19161386.8
(73) Titulaire: H.E.F., 42160 Andrézieux-Bouthéon (FR)
(72) Inventeur: MAURIN-PERRIER, Philippe, F-42680 Saint-Marcellin-en-Forez (FR); HEAU, Christophe, 42650 Saint-Jean-Bonnefonds (FR); GACHON, Yves, F-42170 Saint-Just-Saint-Rambert (FR)
(74) Mandataire: Santarelli
(86) Numéro de dépôt international: PCT/FR2006/002198
(87) Numéro de publication internationale: WO 2007/039679

(56) Documents cités:
- WO-A-00/75394
- ZHOU ET AL: "Hard silicon carbonitride films obtained by RF-plasma-enhanced chemical vapour deposition using the single-source precursor bis(trimethylsilyl)carbodiimide" JOURNAL OF THE EUROPEAN CERAMIC SOCIETY, ELSEVIER SCIENCE PUBLISHERS, BARKING, ESSEX, GB, vol. 26, no. 8, 19 mars 2005 (2005-03-19), pages 1325-1335, XP005294037 ISSN: 0955-2219
- PROBST ET AL: "Development of PE-CVD Si/C/N:H films for tribological and corrosive complex-load conditions" 1 octobre 2005 (2005-10-01), SURFACE AND COATINGS TECHNOLOGY, ELSEVIER, AMSTERDAM, NL, PAGE(S) 355-359 , XP005063529 ISSN: 0257-8972 pages 396-397; figure 1; tableau 1
- WRÓBEL A M ET AL: "Silicon carbonitride films by remote hydrogen-nitrogen plasma CVD from a tetramethyldisilazane source" JOURNAL OF THE ELECTROCHEMICAL SOCIETY ELECTROCHEM. SOC USA, vol. 151, no. 11, novembre 2004 (2004-11), pages C723-C730, XP002393340 ISSN: 0013-4651
- DE MARTINO ET AL: "Mechanical and physical properties of amorphous carbon-based alloys" DIAMOND AND RELATED MATERIALS, ELSEVIER SCIENCE PUBLISHERS, AMSTERDAM, NL, vol. 5, no. 3-5, avril 1996 (1996-04), pages 461-465, XP005309796 ISSN: 0925-9635
- HEYNER R ET AL: "High power deposition and analytics of amorphous silicon carbide films" THIN SOLID FILMS, ELSEVIER-SEQUOIA S.A. LAUSANNE, CH, vol. 258, no. 1/2, 15 mars 1995 (1995-03-15), pages 14-20, XP004010891 ISSN: 0040-6090
- DREER S ET AL: "Critical evaluation of the state of the art of the analysis of light elements in thin films demonstrated using the examples of SiOxNy and AlOxNy films (IUPAC Technical Report)", PURE AND APPLIED CHEMISTRY, vol. 76, no. 6, 2004, pages 1161-1213, XP055037135, International Union of Pure and Applied Chemistry , Research Triangle Park, NC [US] ISSN: 0033-4545, DOI: 10.1351/pac200476061161
- MICHLER J ET AL: "Depth profiling by GDOES: application of hydrogen and d.c. bias voltage corrections to the analysis of thin oxide films", THIN SOLID FILMS, ELSEVIER-SEQUOIA S.A. LAUSANNE, CH, vol. 447-448, 30 January 2004 (2004-01-30) , pages 278-283, XP004493753, ISSN: 0040-6090, DOI: 10.1016/S0040-6090(03)01105-2
- "SPECTRUMA Analytik GmbH - Firmenprofil - Die Produkte und Anwendungsmöglichkeiten", , pages 1-2, XP055209551, Retrieved from the Internet: URL:http://www.schall-virtuell.de/sixcms/m edia.php/386/Firmenprofil SPECTRUMA ANALYTIK.doc [retrieved on 2015-08-26]
- HODOROABA V-D: "Wasserstoffeffekt und -analyse in der GDS - Anwendungen in der Werkstoffforschung (Hydrogen Effect and Analysis in GDS - Applications in Material Science)", DISSERTATION TU DRESDEN [DE], 30 April 2002 (2002-04-30), pages 1-121, XP055250332,
- BARISONE E: "La décharge luminescente comme outil analytique. Influence du taux d'émissiond'électrons secondaires sur ses caractéristiques.", THÈSE UNIVERSITÉ TOULOUSE III - PAUL SABATIER [FR], 13 July 2011 (2011-07-13), pages 1-204, XP055250348, Université de Toulouse [FR]
- GONZALEZ-GAGO C ET AL: "The use of matrix-specific calibrations for oxygen in analytical glow discharge spectrometry", ANALYTICAL AND BIOANALYTICAL CHEMISTRY, vol. 406, no. 29, 22 October 2014 (2014-10-22), pages 7473-7482, XP055249871, Springer-Verlag [DE] ISSN: 1618-2642, DOI: 10.1007/s00216-014-8186-9
- PAATSCH W ET AL: "Quantitative and localized Hydrogen Analysis of electroplated Material", 4TH KURT SCHWABE CORROSION SYMPOSIUM - MECHANISMS OF CORROSION AND CORROSION PREVENTION, HELSINKI UNIVERSITY OF TECHNOLOGY, ESPOO [FI], 13 June 2004 (2004-06-13), - 17 June 2004 (2004-06-17), page 1, XP055641856, Bundesanstalt für Materialforschung und -prüfung (BAM), Berlin [DE]

## Description

### Domaine de l'invention

L'invention concerne la protection de pièces dont la surface est sensible à la corrosion (sèche ou humide) et éventuellement, dans une moindre mesure, au frottement et à l'usure. De façon plus précise, le domaine de l'invention est celui des traitements et revêtements de surface destinés à résister à la corrosion accompagnée ou non de frottement et d'usure.

Les pièces visées par l'invention sont en pratique des pièces métalliques corrodables, comme par exemple de façon non limitative, des aciers, des alliages d'aluminium, des alliages de magnésium, ou des pièces non métalliques revêtues d'un métal corrodable, préférentiellement des pièces mécaniques, de structure ou de surface, par exemple, de façon non exclusive, dans le domaine automobile ou dans celui de la construction.

### Etat de l'art

On connaît depuis très longtemps des procédés de traitement et de revêtement de surface permettant de déposer à la surface des matériaux une couche qui leur assure une bonne résistance à la corrosion (sèche ou humide, acide ou basique). On peut citer pour cela l'ensemble des procédés permettant de déposer des peintures et vernis. Il existe également des procédés électrolytiques permettant de déposer des métaux protecteurs, comme le zinc pour protéger l'acier ou, d'une façon plus générale, le nickel, le chrome, etc, avec des épaisseurs généralement au delà de 10µm. Dans leur ensemble, ces procédés et matériaux confèrent aux pièces revêtues une résistance à la corrosion plus ou moins efficace (selon leur épaisseur, notamment) mais n'apportent généralement (sauf en ce qui concerne le chrome) aucune résistance particulière aux agressions mécaniques telles que frottement et usure.

Par ailleurs, il est connu de protéger la surface de pièces contre le frottement et l'usure avec des couches de céramique telles que des émaux ou encore certaines couches métalliques comme le chrome. Toutefois, dans ce cas, la résistance à la corrosion est faible à moins que la couche protectrice ne soit déposée en très forte épaisseur (typiquement de plusieurs dizaines de microns). Il existe des revêtements plus récents qui présentent une efficacité très grande dans la lutte contre l'usure. Il s'agit de nitrures de métaux de transition tels que TiN, CrN, TiAlN,... Leur très grande dureté leur confère une très grande résistance à l'usure mais les technologies de dépôt actuelles ne permettent pas de les déposer en forte épaisseur de sorte que la protection qu'ils peuvent apporter contre la corrosion est quasiment nulle. Il en est de même des revêtements de carbone amorphe qui protègent efficacement contre le frottement et l'usure mais dont l'épaisseur ne dépasse pas quelques micromètres dans le meilleur des cas, ne pouvant donc pas conduire à une protection efficace contre la corrosion.

Les dépôts électrolytiques de cadmium ou de plomb, longtemps utilisés, sont aujourd'hui abandonnés en raison de la toxicité de ces matériaux et de leur impact négatif sur l'environnement. Les dépôts électrolytiques de chrome ont aussi un impact négatif sur l'environnement, l'évolution de la législation sur les rejets les rend de plus en plus difficiles à mettre en œuvre.

A l'heure actuelle, les solutions permettant aux alliages ferreux de résister à la fois à la corrosion et au frottement et à l'usure sont essentiellement des technologies basées sur la combinaison d'une nitruration et d'une oxydation, mais leur mise en œuvre nécessite des températures élevées, en tout cas supérieures à 500°C. A l'heure actuelle, de nombreuses pièces sont réalisées dans des métaux et alliages pouvant se déformer et/ou perdre leurs caractéristiques mécaniques lorsqu'ils sont chauffés au delà de 200°C.

Le document de Zhou et al. "Hard silicon carbonitride films obtained by RF-plasma-enhanced chemical vapour déposition using the single-source precursor bis(trimethylsilyl)carbodiimide" (JOURNAL OF THE EUROPEAN CERAMIC SOCIETY, ELSEVIER SCIENCE PUBLISHERS, BARKING, ESSEX, GB, vol. 26, no. 8, 19 mars 2005 (2005-03-19), pages 1325-1335, XP005294037 ISSN: 0955-2219) décrit par exemple des revêtements à base de silicium, de carbone, d'hydrogène et d'azote sur un substrat métallique. Les revêtements présentent une épaisseur importante (typiquement supérieure à 20 µm) et une dureté assez élevée (entre 21 et 29 GPa), De plus, ces revêtements sont fragiles et ont une faible adhérence à un substrat métallique ce qui ne leur permet pas de constituer des revêtements efficaces à la fois contre l'usure et la corrosion.

On reste donc actuellement dans le besoin d'un revêtement capable de permettre, à une pièce de structure ou de surface en matériau corrodable qu'elle soit en acier, ou en alliage d'aluminium, ou de magnésium, de résister à la fois à la corrosion et, au moins dans une certaine mesure, au frottement et à l'usure, sans exiger ni température de mise en œuvre élevée, ni épaisseur trop importante.

### Description de l'invention

L'invention est basée sur la découverte surprenante et inattendue des propriétés qu'ont des couches minces de composition complexe à base de silicium et contenant également du carbone, de l'azote et de l'hydrogène, ces quatre éléments Si, C, H et N étant présents dans des proportions bien définies. Il a été constaté que ces couches, même avec des épaisseurs faibles de l'ordre du micron, protègent efficacement, par exemple, des métaux ferreux pendant plusieurs centaines d'heures à l'exposition au brouillard salin, tandis que leur dureté élevée leur confère une résistance à l'usure comparable à celle des nitrures métalliques cités plus haut.

Ce résultat est tout à fait inattendu car il est communément admis et vérifié que, à l'exception du cas de protection dite cathodique (protection de l'acier par du zinc et de l'aluminium), les couches minces présentent inévitablement des défauts constituant autant de porosités permettant aux liquides agressifs d'atteindre et de corroder le substrat, générant ainsi le phénomène bien connu de corrosion par piqûre.

En fait, des couches minces à base de silicium sont déjà connues en soi dans d'autres applications. On connaît ainsi des couches minces contenant de l'oxygène (SiOₓ) utilisées comme couches barrières sur les polymères ou comme traitement déperlant sur des textiles. On connaît également des couches minces de silicium contenant du carbone et de l'hydrogène, souvent appelées « a-SiC:H » qui présentent un intérêt sur le plan tribologique mais ne confèrent aucune protection contre la corrosion.

En l'état des connaissances actuelles, la protection assurée par ces couches minces SiCHN reste encore inexpliquée.

Plus précisément l'invention propose un revêtement en couche mince pour protéger vis-à-vis de la corrosion une pièce constituée d'un matériau métallique corrodable ou d'un matériau revêtu d'une couche métallique corrodable tels que les alliages à base de Fe, Al ou Mg, essentiellement constitué de silicium, de carbone, d'hydrogène et d'azote dans une composition telle que :
- la teneur atomique en hydrogène, mesurée par la technique ERDA, est de 20 ± 5 atomes %,
- la teneur atomique en silicium mesurée par la technique de rétrodiffusion Rutherford (RBS) est comprise entre 15 et 28 atomes %,
- le rapport des concentrations atomiques de l'azote et du carbone (N/C) est supérieur à 0,9,
- la dureté du revêtement en couche mince est inférieure ou égale à 2 100 daN/mm².

Ce revêtement en couche mince a une épaisseur supérieure à 0,1 µm, mais inférieure à 5 µm, et est réalisé par dépôt chimique en phase vapeur assisté par plasma.

La résistance à la corrosion d'une pièce revêtue d'une couche mince respectant les conditions précitées est apparue être excellente. Par ailleurs le respect du seuil maximum pour la dureté du matériau (qui semble important pour la bonne résistance à la corrosion) est apparu tout à fait compatible avec une bonne résistance à l'usure et au frottement. Selon un mode de réalisation préférentiel de l'invention, on utilisera une couche de dureté supérieure à 800 daN/mm².

Il existe un domaine préférentiel de réalisation de l'invention qui correspond au rapport N/C supérieur ou égal à 1 (voire supérieur ou égal à 1,2), toutes les autres conditions restant les mêmes par ailleurs.

Une limite supérieure du rapport N/C a été identifiée aux alentours de 2,5 ; toutefois il ne s'agit que d'une limite expérimentale, les valeurs supérieures n'étant pas accessibles en l'état actuel de la technique ; on peut donc raisonnablement considérer que cette limite n'a pas de signification physique et que l'invention englobe des valeurs N/C plus élevées.

Il est important que la concentration des espèces silicium, carbone et azote soit mesurée par la technique RBS car c'est la seule technique qui ne présente pas d'artefact sur des couches très minces ; par contre, les mesures quantitatives réalisées par les techniques du type SIMS ou ESCA sont à prendre avec beaucoup de précautions. Par ailleurs, en l'état actuel des connaissances, la seule technique fiable de dosage de l'hydrogène est l'ERDA (Elastic Recoil Détection Analysis).

Il est à noter ici que le fait que, selon la définition de l'invention, le revêtement soit « essentiellement » constitué de silicium, de carbone, d'hydrogène et d'azote implique qu'il n'y a pas d'autres composants significatifs, sans toutefois exclure qu'il puisse y avoir des impuretés provenant notamment de la technique de dépôt du revêtement (pour un maximum de quelques pourcents, typiquement de l'ordre de atomes 5 % maximum).

C'est ainsi que, de préférence, la couche SiCHN préconisée par l'invention ne contient pas d'oxygène, la demanderesse ayant mis en évidence que la présence de cet élément dans la couche altère notablement la protection anti-corrosion conférée aux pièces revêtues. Une teneur importante en oxygène dégrade également les propriétés mécaniques et tribologiques des revêtements. Cependant, en fonction des conditions d'élaboration, on pourra retrouver l'oxygène à l'état d'impureté sans que sa présence ait une influence notable sur les propriétés du revêtement.

En pratique un revêtement selon l'invention est apparu efficace dès une épaisseur de 0,1 µm. Des épaisseurs bien supérieures sont possibles (des fortes épaisseurs n'altèrent pas les propriétés de la couche), mais il est apparu inutile de choisir une épaisseur supérieure à 5 µm. Ainsi, cette épaisseur est comprise entre 0,1 µm et 5 µm, de préférence entre 0,5 µm et 2,5 µm, ce qui correspond à un bon compromis entre quantité de matière déposée et efficacité.

Les quatre composants essentiels d'un revêtement selon l'invention, Si, C, H et N, sont présents à des teneurs de plusieurs dizaines de pourcents. Toutefois, il semble avantageux que la teneur atomique en azote soit supérieure à chacune des teneurs atomiques en silicium, en carbone et en hydrogène, de préférence au moins égale à 29 atomes %. Compte tenu de la présence des autres composants, la teneur en azote est de préférence au plus égale à 40 atomes %, mais il semble tout particulièrement efficace que cette teneur soit comprise entre 29 atomes % et 33 atomes %.

De même que l'hydrogène, le silicium et le carbone ont avantageusement des teneurs comprises entre 15 atomes % et 26 atomes %.

Bien que la définition de l'invention ne mentionne pour la dureté qu'un seuil maximum, on comprend aisément que la résistance à l'usure et au frottement sera d'autant meilleure que cette dureté sera élevée, dans le respect de ce seuil maximum ; en pratique on peut estimer qu'un revêtement selon l'invention combine une bonne résistance à la corrosion et une bonne résistance à l'usure et au frottement dès lors que la dureté dépasse une valeur de l'ordre de 800 daN/mm².

Bien que plusieurs types de procédés soient envisageables pour mettre en œuvre des revêtements, l'invention préconise d'utiliser le procédé de dépôt chimique en phase vapeur assisté par plasma qui consiste à décomposer un précurseur gazeux à l'aide des espèces énergétiques générées par une décharge électrique.

Il est à noter que ce type de technique implique des températures inférieures à 500 °C, ne présentant donc pas, notamment, les inconvénients des traitements de nitruration-oxydation.

Le revêtement conforme à l'invention peut évidemment être utilisé isolément pour assurer la protection d'un substrat contre la corrosion et le frottement, mais son usage, en combinaison avec un autre matériau permettant de conférer à la surface traitée de nouvelles propriétés, fait également partie de l'invention ; c'est ainsi que l'invention couvre, notamment, l'utilisation d'une couche mince de composition de SiCHN telle que définie ci-dessus, comme sous-couche que l'on revêt ensuite d'un dépôt de carbone amorphe, avantageusement de type DLC (c'est-à-dire Diamond Like Carbon ou Carbone Diamant Amorphe dopé ou non) de façon à apporter aux pièces traitées un supplément de résistance à l'usure et au frottement en complément à la très bonne résistance à la corrosion apportée par la sous-couche SiCHN mais que n'apporte pas le carbone amorphe . Un tel dépôt de carbone amorphe aura de préférence une épaisseur comprise entre 0,1 et 5 µm.

L'invention couvre également une pièce dont au moins une couche superficielle est en un matériau métallique corrodable (notamment en alliage ferreur, en alliage d'aluminium ou en alliage de magnésium) et qui est revêtu d'une couche mince du type précité.

### Exemples de revêtements, conformes ou non à l'invention

Les exemples qui suivent concernent des couches réalisées par la technique du dépôt chimique en phase vapeur assisté par plasma, sur des substrats d'un même type (aciers au carbone) pour faciliter la comparaison des résultats et performances. Leur épaisseur a été mesurée entre 1,7 et 3,7 µm.

Ces couches ont été caractérisées par la technique ERDA en ce qui concerne leur teneur en hydrogène, par RBS en ce qui concerne les autres éléments; la résistance à la corrosion conférée au substrat par la couche a été mesurée par le temps nécessaire à l'apparition de la première piqûre lors de l'exposition au test de brouillard salin (norme ISO9227), une durée supérieure à 200 h étant considérée comme acceptable, tandis que des valeurs inférieures sont considérées comme correspondant à une résistance insuffisante (les valeurs indiquées sont les moyennes de trois mesures de tenue en corrosion.

Par ailleurs, les revêtements ont été testés en terme de résistance à l'usure par un test de type/bille disque. La bille en acier, de 10 mm de diamètre, a été revêtue par les divers dépôts. Le test consiste à faire frotter la bille contre un disque en acier. Une charge de 5 N est appliquée sur la bille. Le disque tourne à une vitesse de rotation de 50 tours par minute pendant 5000 tours. Le diamètre de la piste de frottement étant de 20 mm, la distance parcourue en fin de test est de 314 m. En fin de test, le faciès d'usure sur la bille revêtue se présente sous la forme d'une calotte. Le diamètre de cette calotte donne une indication sur la résistance à l'usure du dépôt. La calotte d'usure est d'autant plus petite que le dépôt a une forte résistance à l'usure.

Le tableau suivant résume les résultats obtenus avec des couches conformes à l'invention et d'autres non conformes :

| **Exemple** | **H at %** | **Si at %** | **C at %** | **N at %** | **N/C** | **Dureté (daN/mm²)** | **Résistance à la corrosion (h)** | **Conformité à l'invention** | **Epaisseur (µm)** | **Diamètre usé (µm)** |
|---|---|---|---|---|---|---|---|---|---|---|
| 1 | 20 | 20 | 60 | 0 | 0 | 3 300 | 24 | NC | 2,3 | 180 |
| 2 | 20 | 20 | 60 | 0 | 0 | 2 000 | 120 | NC | 2 | 260 |
| 3 | 20 | 12,8 | 67,2 | 0 | 0 | 2 100 | 24 | NC | 3,4 | 240 |
| 4 | 20 | 6 | 74 | 0 | 0 | 2 050 | 88 | NC | 3,7 | 220 |
| 5 | 20 | 25,2 | 19,6 | 35,2 | 1,80 | 1 750 | 348 | C | 2,7 | 270 |
| 6 | 21,2 | 26 | 23,6 | 29,2 | 1,24 | 1 950 | 808 | C | 2,1 | 230 |
| 7 | 22,2 | 25,4 | 19,4 | 32,7 | 1,69 | 2050 | 702 | C | 1,7 | 230 |
| 8 | 20 | 23,2 | 16,8 | 40 | 2,38 | 1 615 | 472 | C | 1,7 | 300 |
| 9 | 20 | 26,4 | 32,8 | 20,8 | 0,63 | 2 100 | 56 | NC | 2,5 | 220 |
| 10 | 19,2 | 28 | 39,2 | 13,6 | 0,35 | 2 600 | 24 | NC | 3 | 200 |
| 11 | 20 | 26 | 32,8 | 21,2 | 0,65 | 2 000 | 120 | NC | 2,8 | 260 |
| 12 | 19,2 | 24,8 | 30,4 | 25,6 | 0,84 | 1 700 | 64 | NC | 1,9 | 300 |
| 13 | 20 | 26 | 28,8 | 25,2 | 0,88 | 2 100 | 168 | NC | 3,1 | 230 |
| 14 | Couche de l'exemple 6 + DLC | | | | | 3400 | 784 | C | 6,0 | 150 |
| 15 | substrat non revêtu | | | | | 850 | <6 | témoin | / | 620 |

Dans l'exemple 14, il s'agit d'un substrat revêtu de la même couche SiCHN que celle décrite dans l'exemple 6 ; cette couche étant elle-même revêtue d'une couche de DLC d'épaisseur 5 µm. Naturellement, la dureté ayant été mesurée par dessus correspond à celle de la couche superficielle c'est-à-dire de la couche de DLC.

L'exemple 15 illustre le comportement d'un acier à outil sans revêtement.

On peut noter que les exemples 1 à 4 justifient l'intérêt de la présence de l'azote, tandis que les exemples 9 à 12 montrent l'importance du rapport N/C, l'exemple 13 paraissant être limite au point de justifier le seuil de 0.9 pour le rapport N/C.

En ce qui concernent les « bons » exemples (lettre C dans la dernière colonne), on peut noter que leur dureté est sensiblement inférieure au seuil de 2100 daN/mm², et que leur rapport N/C est sensiblement supérieur à 1 (au moins 1.2 en ce qui concerne l'exemple 6) avec une valeur allant jusqu'à 2.4 (exemple 8) ; la teneur en azote est supérieure à chacune des teneurs en Si, C ou H (au moins 29 atomes %, avec un exemple à 40% sans que cela apparaisse une limite).

La comparaison des deux meilleurs exemples (6 et 7) semble montrer que la teneur en H peut aussi bien être supérieure qu'inférieure à celle de Si, les deux éléments étant présents à des teneurs atomiques comprises à l'intérieur d'une même plage 20 ± 5 atomes % ; par ailleurs, la teneur en carbone y est comprise dans la même plage précitée, tandis que la teneur en azote y est supérieure à chacune des teneurs en Si, C et H, à l'intérieur d'une plage de 29 atomes % à 40 atomes %). On peut raisonnablement considérer que ces corrélations sont avantageuses, pour obtenir une bonne résistance à la corrosion.

On peut remarquer également à travers les exemples et contre-exemples mentionnés, qu'il n'existe pas de corrélation évidente entre tenue corrosion et épaisseur. A titre d'illustration, l'exemple n° 4, bien que le plus épais, présente une tenue corrosion de seulement 88 h. Parmi les exemples conformes, le dépôt le plus performant en corrosion (exemple n° 6) n'est pas le plus épais.

Les valeurs d'usure des dépôts conformes sont comprises dans une fourchette comparable à celle obtenue pour les dépôts non conformes et sont caractéristiques des valeurs d'usure sur revêtement dur. L'exemple 14 montre le gain en résistance à l'usure lorsqu'un dépôt conforme est revêtu de DLC. A titre d'illustration, l'usure d'une bille en acier non revêtue donne une usure 2,1 à 2,7 fois plus forte que les dépôts conformes, le gain atteignant 4,1 lorsqu'un dépôt de DLC est ajouté sur un revêtement conforme.

Des substrats en acier au carbone, en alliage d'aluminium et en alliage de magnésium, ont été revêtus d'une couche d'environ 1 micron, dont la composition est conforme aux enseignements précédents, puis par un dépôt de carbone amorphe de type DLC, avec une épaisseur de 5 µm. Non seulement on a constaté une bonne résistance à la corrosion conforme à celle des bons exemples, mais on a en outre observé une résistance à l'usure améliorée ainsi qu'un abaissement du coefficient de frottement.

## Revendications

1. Revêtement en couche mince pour protéger vis-à-vis de la corrosion une pièce en un matériau métallique corrodable, essentiellement constitué de silicium, de carbone, d'hydrogène et d'azote dans une composition telle que le rapport des concentrations atomiques de l'azote et du carbone (N/C) est supérieur à 0,9, **caractérisé en ce que** :
- la teneur atomique en hydrogène, mesurée par la technique ERDA, est de 20 ± 5 atomes %,
- la teneur atomique en silicium mesurée par la technique de rétrodiffusion Rutherford (RBS) est comprise entre 15 et 28 atomes %,
- la dureté du revêtement en couche mince est inférieure ou égale à 2 100 daN/mm²,
- **en ce que** son épaisseur est supérieure à 0,1 µm, mais inférieure à 5 µm et
- **en ce qu'**il est réalisé par dépôt chimique en phase vapeur assisté par plasma.

2. Revêtement en couche mince selon la revendication 1, **caractérisé en ce que** le rapport des concentrations atomiques en azote et carbone (N/C) est supérieur à 1.

3. Revêtement en couche mince selon la revendication 2, **caractérisé en ce que** le rapport des concentrations atomiques en azote et en carbone (N/C) est au moins égal à 1,2.

4. Revêtement en couche mince selon l'une quelconque des revendications 1 à 3, **caractérisé en ce qu'**il comporte d'éventuelles impuretés pour un maximum de 5 atomes %.

5. Revêtement en couche mince selon l'une quelconque des revendications 1 à 4, **caractérisé en ce que** son épaisseur est comprise entre 0,5 et 2,5 µm.

6. Revêtement en couche mince selon l'une quelconque des revendications 1 à 5, **caractérisé en ce que** la teneur atomique en azote est supérieure à chacune des teneurs atomiques en silicium, en carbone et en hydrogène.

7. Revêtement en couche mince selon la revendication 6, **caractérisé en ce que** la teneur atomique en azote est au moins égale à 29 atomes %.

8. Revêtement en couche mince selon la revendication 7, **caractérisé en ce que** la teneur atomique en azote est au plus égale à 40 atomes %.

9. Revêtement en couche mince selon la revendication 8, **caractérisé en ce que** la teneur atomique en azote est au plus égale à 33 atomes %.

10. Revêtement en couche mince selon l'une quelconque des revendications 1 à 9, **caractérisé en ce que** les teneurs atomiques du silicium et du carbone sont comprises entre 15 atomes % et 26 atomes %.

11. Revêtement en couche mince selon l'une quelconque des revendications 1 à 10, **caractérisé en ce que** la dureté est au moins égale à 800 daN/mm².

12. Revêtement en couche mince selon l'une quelconque des revendications 1 à 11, **caractérisé en ce qu'**il est recouvert d'une couche de carbone amorphe dopé ou non.

13. Pièce mécanique dont au moins une couche superficielle est en matériau métallique corrodable et qui est en revêtue d'une couche mince conforme à l'une quelconque des revendications 1 à 12.

14. Pièce selon la revendication 13, **caractérisée en ce que** la couche mince est recouverte d'une couche de carbone amorphe dopé ou non.

15. Utilisation d'un revêtement en couche mince pour protéger vis-à-vis de la corrosion une pièce en un matériau métallique corrodable, le revêtement étant essentiellement constitué de silicium, de carbone, d'hydrogène et d'azote dans une composition telle que :
- la teneur atomique en hydrogène, mesurée par la technique ERDA, est de 20 ± 5 atomes %,
- la teneur atomique en silicium mesurée par la technique de rétrodiffusion Rutherford (RBS) est comprise entre 15 et 28 atomes %,
- le rapport des concentrations atomiques de l'azote et du carbone (N/C) est supérieur à 0,9,
- la dureté du revêtement en couche mince est inférieure ou égale à 2 100 daN/mm^{2,}
- son épaisseur est supérieure à 0,1 µm, mais inférieure à 5 µm, et
- le revêtement en couche mince est réalisé par dépôt chimique en phase vapeur assisté par plasma.

## Patentansprüche

1. Dünnschichtbeschichtung zum Schutz eines Bauteils aus einem korrodierbaren metallischen Werkstoff gegen Korrosion, das im Wesentlichen aus Silizium, Kohlenstoff, Wasserstoff und Stickstoff in einer solchen Zusammensetzung besteht, dass das Verhältnis der Atomkonzentrationen von Stickstoff und Kohlenstoff (N/C) größer als 0,9 ist, **dadurch gekennzeichnet, dass**
- der Atomgehalt von Wasserstoff, gemessen mit der ERDA-Technik, 20 ± 5 Atom-%, beträgt,
- der Atomgehalt von Silizium, gemessen mit der Rutherford-Rückstreuungstechnik (RBS), zwischen 15 und 28 Atom-% beträgt,
- die Härte der Dünnschichtbeschichtung kleiner oder gleich 2 100 daN/mm² ist,
- dass ihre Dicke größer als 0,1 µm, aber kleiner als 5 µm ist, und
- dass sie durch plasmaunterstützte chemische Gasphasenabscheidung hergestellt ist.

2. Dünnschichtbeschichtung nach Anspruch 1, **dadurch gekennzeichnet, dass** das Verhältnis der Atomkonzentrationen von Stickstoff und Kohlenstoff (N/C) größer als 1 ist.

3. Dünnschichtbeschichtung nach Anspruch 2, **dadurch gekennzeichnet, dass** das Verhältnis der Atomkonzentrationen von Stickstoff und Kohlenstoff (N/C) mindestens gleich 1,2 ist.

4. Dünnschichtbeschichtung nach einem der Ansprüche 1 bis 3, **dadurch gekennzeichnet, dass** sie eventuelle Verunreinigungen bis zu maximal 5 Atom-% enthält.

5. Dünnschichtbeschichtung nach einem der Ansprüche 1 bis 4, **dadurch gekennzeichnet, dass** ihre Dicke zwischen 0,5 und 2,5 µm beträgt.

6. Dünnschichtbeschichtung nach einem der Ansprüche 1 bis 5, **dadurch gekennzeichnet, dass** der Atomgehalt von Stickstoff höher als der jeweilige Atomgehalt von Silizium, Kohlenstoff und Wasserstoff ist.

7. Dünnschichtbeschichtung nach Anspruch 6, **dadurch gekennzeichnet, dass** der Atomgehalt von Stickstoff mindestens gleich 29 Atom-% ist.

8. Dünnschichtbeschichtung nach Anspruch 7, **dadurch gekennzeichnet, dass** der Atomgehalt von Stickstoff höchstens gleich 40 Atom-% ist.

9. Dünnschichtbeschichtung nach Anspruch 8, **dadurch gekennzeichnet, dass** der Atomgehalt von Stickstoff höchstens gleich 33 Atom-% ist.

10. Dünnschichtbeschichtung nach einem der Ansprüche 1 bis 9, **dadurch gekennzeichnet, dass** der Atomgehalt von Silizium und der von Kohlenstoff zwischen 15 Atom-% und 26 Atom-% beträgt.

11. Dünnschichtbeschichtung nach einem der Ansprüche 1 bis 10, **dadurch gekennzeichnet, dass** die Härte zumindest gleich 800 daN/mm² ist.

12. Dünnschichtbeschichtung nach einem der Ansprüche 1 bis 11, **dadurch gekennzeichnet, dass** sie mit einer Schicht aus dotiertem oder undotiertem amorphem Kohlenstoff bedeckt ist.

13. Mechanisches Bauteil, von dem mindestens eine Oberflächenschicht aus einem korrodierbaren metallischen Werkstoff besteht und das mit einer Dünnschicht nach einem der Ansprüche 1 bis 12 beschichtet ist.

14. Bauteil nach Anspruch 13, **dadurch gekennzeichnet, dass** die Dünnschicht mit einer Schicht aus dotiertem oder undotiertem amorphem Kohlenstoff bedeckt ist.

15. Verwendung einer Dünnschichtbeschichtung zum Schutz eines Bauteils aus einem korrodierbaren metallischen Werkstoff gegen Korrosion, wobei die Beschichtung im Wesentlichen aus Silizium, Kohlenstoff, Wasserstoff und Stickstoff in einer solchen Zusammensetzung besteht, dass
- der Atomgehalt von Wasserstoff, gemessen mit der ERDA-Technik, 20 ± 5 Atom-%, beträgt,
- der Atomgehalt von Silizium, gemessen mit der Rutherford-Rückstreuungstechnik (RBS), zwischen 15 und 28 Atom-% beträgt,
- das Verhältnis der Atomkonzentrationen von Stickstoff und Kohlenstoff (N/C) größer als 0,9 ist,
- die Härte der Dünnschichtbeschichtung kleiner oder gleich 2 100 daN/mm² ist,
- ihre Dicke größer als 0,1 µm, aber kleiner als 5 µm ist, und
- die Dünnschichtbeschichtung durch plasmaunterstützte chemische Gasphasenabscheidung hergestellt ist.

## Claims

1. A thin layer coating for corrosion protection of a part made of a corrodible metallic material, substantially consisting of silicon, carbon, hydrogen and nitrogen in a composition such that the ratio of the atomic concentrations of the nitrogen and of the carbon (N/C) is greater than 0.9, **characterized in that**:
- the atomic content of hydrogen, measured by the ERDA technique, is 20 ± 5 atomic %,
- the atomic content of silicon measured by the Rutherford Backscattering technique (RBS) is comprised between 15 and 28 atomic %,
- the hardness of the thin layer coating is less than or equal to 2 100 daN/mm²,
- and **in that** its thickness is greater than 0.1 µm, but less than 5 µm, and
- **in that** it is formed by plasma assisted chemical vapor deposition.

2. A thin layer coating according to claim 1, **characterized in that** the ratio of the atomic concentrations of nitrogen and carbon (N/C) is greater than 1.

3. A thin layer coating according to claim 2, **characterized in that** the ratio of the atomic concentrations of nitrogen and carbon (N/C) is at least equal to 1.2.

4. A thin layer coating according to any one of claims 1 to 3, **characterized in that** it comprises possible impurities for a maximum of 5 atomic %.

5. A thin layer coating according to any one of claims 1 to 4, **characterized in that** its thickness is comprised between 0,5 and 2,5µm.

6. A thin layer coating according to any one of claims 1 to 5, **characterized in that** the atomic content of nitrogen is greater than each of the atomic contents of silicon, carbon and hydrogen.

7. A thin layer coating according to claim 6, **characterized in that** the atomic content of nitrogen is at least equal to 29 atomic %.

8. A thin layer coating according to claim 7, **characterized in that** the atomic content of nitrogen is at most equal to 40 atomic %.

9. A thin layer coating according to claim 8, **characterized in that** the atomic content of nitrogen is at most equal to 33 atomic %.

10. A thin layer coating according to any one of claims 1 to 9, **characterized in that** the atomic contents of silicon and carbon are comprised between 15 atomic % and 26 atomic %.

11. A thin layer coating according to any one of claims 1 to 10, **characterized in that** the hardness is at least equal to 800 daN/mm².

12. A thin layer coating according to any one of claims 1 to 11, **characterized in that** it is covered with a layer of amorphous carbon which may or may not be doped.

13. A mechanical part of which at least a surface layer is of corrodible metallic material and which is covered with a thin layer in accordance with any one of claims 1 to 12.

14. A part according to claim 1, **characterized in that** the thin layer is covered with a layer of amorphous carbon which may or may not be doped.

15. Use of a thin layer coating for corrosion protection of a part of corrodible metallic material, the coating substantially consisting of silicon, carbon, hydrogen and nitrogen in a composition such that:
- the atomic content of hydrogen, measured by the ERDA technique, is 20 ± 5 atomic %,
- the atomic content of silicon measured by the Rutherford Backscattering technique (RBS) is comprised between 15 and 28 atomic %,
- the ratio of the atomic concentrations of the nitrogen and the carbon (N/C) is greater than 0.9,
- the hardness of the thin layer coating is less than or equal to 2 100 daN/mm²,
- its thickness is greater than 0.1 µm, but less than 5 µm, and
- the thin layer coating is formed by plasma assisted chemical vapor deposition.
